# EUROPÄISCHE PATENTSCHRIFT

(11) **EP 3 766 316 B1**
(45) Veröffentlichungstag und Bekanntmachung des Hinweises auf die Patenterteilung: **07.05.2025**
(21) Anmeldenummer: 19706532.9
(22) Anmeldetag: 18.02.2019
(51) Int. Cl.: H05K 7/20, F25B 21/02, G06F 1/20

(54) **SCHRANK ZUR INSTALLATION VON IT-, EDV-, NETZWERK- UND/ODER TELEKOMMUNIKATIONSSYSTEMEN**
CABINET FOR INSTALLING IT, EDP, NETWORK AND/OR TELECOMMUNICATIONS SYSTEMS
ARMOIRE D'INSTALLATION DE SYSTÈMES DE TI, DE TRAITEMENT INFORMATIQUE DE DONNÉES, DE RÉSEAU ET/OU DE TÉLÉCOMMUNICATION

(30) Priorität: 13.03.2018 DE 102018105768
(43) Veröffentlichungstag der Anmeldung: 20.01.2021
(73) Patentinhaber: Apelsin Enterprises GmbH, 64342 Seeheim-Jugenheim (DE)
(72) Erfinder: TENNIGKEIT, Jörg, 64342 Seeheim-Jugenheim (DE)
(74) Vertreter: Freischem & Partner Patentanwälte mbB
(86) Internationale Anmeldenummer: PCT/EP2019/053947
(87) Internationale Veröffentlichungsnummer: WO 2019/174861

(56) Entgegenhaltungen:
- WO-A1-2014/131460
- WO-A2-02/17698
- DE-A1- 3 730 830
- DE-B- 1 187 284
- US-A1- 2012 279 233

## Beschreibung

Die Erfindung betrifft einen Schrank zur Installation von IT-, EDV-, Netzwerk- und/oder Telekommunikationssystemen gemäß dem Oberbegriff des Patentanspruchs 1.

Aus WO 02/17698 A2 ist ein Temperatur-Management-System für elektronische Komponenten abstrakt beschrieben, das mindestens zwei Wärmepumpen und ein Wärmerohr aufweist. Es wird auch auf die Verwendung solcher Systeme in Verbindung mit Schränken verwiesen und darauf, dass dann außenseitig Lüfter und Wärmeableitelemente vorgesehen sein sollen. Eine konkrete Anordnung einzelner Elemente in oder an dem Korpus eines Schranks zur Installation von IT-, EDV-, Netzwerk- und/oder Telekommunikationssystemen ist in dieser Druckschrift jedoch nicht beschrieben.

Aus KR 10 2004 0 061 286 A ist ein Kühlsystem mit Innen-Kühlstrukturen, Innenlüfter, Außen-Kühlstrukturen, Außenlüfter und durch den Korpus eines Schranks führenden Wärmerohren bekannt.

Aus der Patentschrift DE 10 2010 030 683 B4 ist eine Kühlanordnung für einen Schrank zur Installation von IT-, EDV-, Netzwerk- und/oder Telekommunikationssystemen und Verfahren zum Kühlen eines solchen Schranks bekannt. Diese Kühlanordnung erfordert relativ viel Platz und verursacht Betriebsgeräusche, die in manchen Anwendungsfällen ungewünscht sein können.

Der Erfindung liegt die Aufgabe zugrunde, einen Schrank zur Installation von IT-, EDV-, Netzwerk- und/oder Telekommunikationssystemen zur Verfügung zu stellen, der effizient und möglichst geräuscharm gekühlt werden kann und zugleich Möglichkeiten für einen effizienten physikalischen Schutz bietet, insbesondere Schutz vor Staub und/oder Schutz vor Feuchtigkeit bzw. Löschwasser und/oder Schutz vor mechanischen Aufbruchversuchen und/oder Brandschutz.

Die Lösung der Aufgabe erfolgt erfindungsgemäß mit den Merkmalen der unabhängigen Ansprüche. Weitere praktische Ausführungsformen sind in Verbindung mit den abhängigen Ansprüchen beschrieben.

Ein erfindungsgemäßer Schrank zur Installation von IT-, EDV-, Netzwerk- und/oder Telekommunikationssystemen umfasst einen Korpus sowie mindestens eine verschließbare Öffnung zur Installation und Wartung von innerhalb des Korpus anordenbaren Systemen, wobei eine passive Kühlung ohne außenseitig des Korpus angeordnete Lüfter vorgesehen ist, wobei zur Realisierung der passiven Kühlung nur in oder nur an dem Korpus mindestens ein Peltier-Element mit einer Warmseite und einer Kaltseite angeordnet ist, wobei die Warmseite über mindestens ein wärmeleitend verbundenes Wärmerohr (insbesondere in Form einer "heat pipe" oder mehrerer "heat pipes") mit mindestens einer außenseitig des Korpus angeordneten Außen-Kühlstruktur funktional verbunden ist.

Um die Kühlung im Inneren des Korpus besonders effizient zu gestalten, ist es bei dem erfindungsgemäßen Schrank vorgesehen, eine Zwangs-Luftführung eines Kühlluftstromes zumindest teilweise durch eine Innen-Kühlstruktur zu leiten. Eine derartige Innen-Kühlstruktur kann insbesondere rippenartig, lamellenartig und/oder labyrinthartig ausgebildet sein. Dazu kann beispielsweise ein Kühlluftstrom, der innerhalb des Korpus von einer Warmseite zu einer Kaltseite geführt ist, mittels einer geeignet ausgebildeten Schottung zwangsweise durch eine Innen-Kühlstruktur geleitet werden.

Fener ist bei einem erfindungsgemäßen Schrank mindestens eine Wand als Isolationswand ausgebildet. Darunter sind insbesondere solche Wände zu verstehen, die mindestens eine Materialschicht aus einem Isoliermaterial aufweisen. Beispielsweise können derartige Isolationswände dadurch gebildet sein, dass zwei oder mehr Blechelemente das Isoliermaterial umschließend angeordnet sind, insbesondere indem die Blechelemente unmittelbar innenseitig und außenseitig des Isoliermaterials angeordnet sind. Dabei ist die Isolationsschicht vorzugsweise um ein Vielfaches größer als die Blechstärke, beispielsweise mindestens um das 5-fache, mindestens um das 10-fache oder mindestens um das 15-fache oder 20-fache. Dies hat den Vorteil, dass die Wärmeabfuhr aus dem Korpus nach außen nicht großflächig über die gesamten Wände erfolgt, sondern gezielt über die Wand durchdringende wärmeleitende Elemente erfolgen kann, wie beispielsweise über Wärmerohre (heat pipes) oder über sonstige wärmeleitende Elemente, wie beispielsweise Metallelemente.

Mit "nur in dem Korpus" ist gemeint, dass ein oder mehrere Peltier-Elemente ausschließlich innerhalb des Korpus angeordnet sind. In diesem Fall sind außenseitig des Korpus keine Peltier-Elemente als Teil der Kühlung angeordnet.

Mit "nur an dem Korpus" ist eine Anordnung von einem oder mehreren Peltier-Elementen ausschließlich außenseitig an dem Korpus gemeint. In diesem Fall sind als Teil der Kühlung keine Peltier-Elemente in dem Korpus angeordnet.

Mit einem derartig ausgebildeten Schrank kann eine effiziente und insbesondere geräuscharme Kühlung insoweit realisiert werden, als keine drehenden Teile für die Kühlung des Schranks außerhalb des Korpus benötigt werden bzw. angeordnet werden müssen. Ein erfindungsgemäßer Schrank ist damit auch sehr wartungsarm und kann im Einzelfall in Bezug auf seine übliche Gebrauchsdauer (im Folgenden auch Lebensdauer genannt) als wartungsfrei bezeichnet werden.

Das mindestens eine Peltier-Element oder die mehreren Peltier-Elemente und Wärmerohre (insbesondere "heat pipes") sind vorzugsweise so ausgelegt, dass die Temperatur in dem Schrank bei bestimmungsgemäßer Verwendung des Schranks auf eine Temperatur unterhalb der Umgebungstemperatur gebracht werden kann, insbesondere auf Temperaturen unter 30°C, bevorzugt unter 25°C und weiter bevorzugt unter 20°C. Dies ist insoweit von Vorteil, als in dem Schrank installierte IT-, EDV-, Netzwerk- und/oder Telekommunikationssysteme bei Temperaturen unter 20°C sicher nicht überhitzt werden und deren Lebensdauer maximiert werden kann.

Ein besonderer Vorteil der Erfindung besteht darin, dass sich mit dem erfindungsgemäßen Konzept ein effizientes Luft-Luft-System realisieren lässt, bei welchem sowohl innerhalb des Schranks als auch außerhalb des Schranks Luft als Kühlmedium eingesetzt werden kann und Flüssigkeit ausschließlich teilweise innerhalb der gekapselten Wärmerohre vorhanden ist. Dabei benötigt diese Flüssigkeit keinen gesonderten externen "Antrieb", und die Gefahr eines Austretens dieser Flüssigkeit ist im Vergleich zu flüssigkeitsgekühlten Systemen mit über Pumpen angetriebenen Flüssigkeitskühlungen in Schränken gering.

In einer praktischen Ausführungsform eines erfindungsgemäßen Schranks ist das mindestens eine Peltier-Element innerhalb des Korpus angeordnet, und mindestens ein Wärmerohr ist durch mindestens eine Wand des Korpus geführt. Ebenfalls möglich ist es insoweit auch, eine Vielzahl von Wärmerohren (insbesondere "heat pipes") durch mindestens eine Wand des Korpus führend anzuordnen. Bei dieser Ausführungsform kann das Peltier-Element besonders manipulationssicher innerhalb des Korpus angeordnet sein, wodurch sich eine besonders hohe Funktionssicherheit ergibt.

In einer weiteren praktischen Ausführungsform eines erfindungsgemäßen Schranks ist die Warmseite des mindestens einen Peltier-Elements unmittelbar an einer Innenwand des Korpus anliegend und/oder die Kaltseite des mindestens einen Peltier-Elements unmittelbar an einer Außenwand des Korpus anliegend angeordnet. Bei beiden Varianten ergibt sich eine besonders platzsparende Anordnung des Peltier-Elements, wobei die vorstehend erwähnte Funktionssicherheit vor allem bei der Variante gewährleistet ist, bei welcher die Warmseite des mindestens einen Peltier-Elements unmittelbar an einer Innenwand des Korpus anliegend angeordnet ist. Die Anordnung des mindestens einen Peltier-Elements mit der Kaltseite unmittelbar an einer Außenwand des Korpus hat den Vorteil, dass der Innenraum des erfindungsgemäßen Schranks nicht durch das Peltier-Element verkleinert wird, was insbesondere bei sehr kompakten erfindungsgemäßen Schränken von Nutzen sein kann.

In einer weiteren praktischen Ausführungsform eines erfindungsgemäßen Schranks erstreckt sich die mindestens eine Kühlstruktur (oder die Summe aus mehreren Kühlstrukturen) über einen Teilbereich der Fläche einer Außenwand des Korpus und/oder es erstreckt sich das mindestens eine Peltier-Element (oder die Summe aus mehreren Peltier-Elementen) über einen Teil der Fläche einer Innenwand des Korpus. Vorzugsweise erstrecken sich die mindestens eine Kühlstruktur und/oder das mindestens eine Peltier-Element über einen Teilbereich der Fläche der Außenwand des Korpus bzw. der Innenwand des Korpus, beispielsweise über mindestens 5%, vorzugsweise mindestens 10% und weiter bevorzugt mindestens 15% oder mindestens als 20% der Fläche einer Innenwand des Korpus. Dies hat den Vorteil, dass die Fläche in dem jeweiligen Teilbereich weitestgehend zur direkten Herausförderung von Wärme aus dem Inneren des erfindungsgemäßen Schranks bzw. des Korpus benutzt werden kann. Es hat sich gezeigt, dass schon mit einem Teilbereich einer Fläche eines Peltier-Elements an einer Außenwand bzw. Innenwand, der sich etwa über 20% einer Wand eines Korpus erstreckt, eine sehr effiziente Kühlung möglich ist. Dies gilt insbesondere für den Fall, dass ein in dem Schrank zirkulierendes Fluid, insbesondere Luft, vollständig oder zu einem Anteil von deutlich mehr als 50%bei jeder Zirkulation zwangsweise zumindest entlang eines Teils dieses Teilbereichs unmittelbar oder mittelbar entlang geleitet wird.

Wenn das mindestens eine Peltier-Element außerhalb des Korpus angeordnet ist, ist es bevorzugt, wenn die Wärmerohre ("heat pipes") in unmittelbarer Umgebung des Peltier-Elements wärmeleitend mit diesem verbunden angeordnet sind. In diesem Fall ergibt sich eine vorteilhafte und effiziente Wärmeübertragung von der Warmseite des Peltier-Elements zu den Wärmerohren ("heat pipes").

Um dies zu realisieren, ist vorzugsweise die Kaltseite des Peltier-Elements unmittelbar an der Außenseite des Korpus anliegend angeordnet, wobei die Warmseite des Peltier-Elements wärmeleitend mit dem einen Wärmerohr ("heat pipes") oder den mehreren Wärmerohren ("heat pipes") verbunden ist.

In einer weiter bevorzugten Ausführungsform ist mindestens ein wärmeleitendes Element, zum Beispiel ein Metallblock oder ein sonstiges wärmeleitendes Element, durch eine Wand des Korpus hindurchragend angeordnet, so dass Wärme über dieses wärmeleitende Element primär durch den Korpus hindurch nach außen übertragen werden kann. Ein solches wärmeleitendes Element oder mehrere solcher wärmeleitenden Elemente sind weiter bevorzugt mit mindestens einer Innen-Kühlstruktur wärmeleitend verbunden. Dabei kann es sich insbesondere um ein rippenartig, lamellenartig oder labyrinthartig ausgebildetes Kühlelement handeln.

In einer weiteren praktischen Ausführungsform sind die Wärmerohre ("heat pipes") außerhalb des Korpus angeordnet, wobei ein Ende der Wärmerohre ("heat pipes") jeweils wärmeleitend mit Außen-Kühlstrukturen verbunden ist und ein anderes Ende in unmittelbarer Umgebung des mindestens einen Peltier-Elements angeordnet ist. In diesem Fall kann eine weitere außenseitige Wärmeübertragung zwischen dem Peltier-Element und einer oder mehreren Außen-Kühlstrukturen mittels der Wärmerohre ("heat pipes") erfolgen.

Ein erfindungsgemäßer Schrank weist vorzugsweise in dem Korpus Mittel zur Aufnahme einer Haltevorrichtung und/oder eine Haltevorrichtung zur Aufnahme von und Verbindung mit IT-, EDV-, Netzwerk- und/oder Telekommunikationssystemen in genormten Standardgrößen auf. Dies können insbesondere sich in vertikaler Richtung erstreckende Schienen sein, die zur Verschraubung von 17-Zoll, 19-Zoll, 21-Zoll oder anderen Standardgrößen gebauten Systemen ausgelegt sind. Optional können die Ebenen, z.B. eine 19-Zoll-Ebene, verschiebbar ausgebildet sein.

Die Erfindung betrifft insbesondere kompakte Schränke mit einem Schrankvolumen, das zur Aufnahme von 1 bis 12 Höheneinheiten, weiter vorzugsweise mit 1 bis 10 Höheneinheiten und besonders bevorzugt mit 1 bis 8 Höheneinheiten ausgelegt ist. Dabei entspricht eine Höheneinheit einem Höhenmaß von 1¾-Zoll.

Ein innerhalb eines erfindungsgemäßen Schranks geführter Luftstrom kann insbesondere dadurch in bestimmten Bereichen des Korpus gezielt geführt und angetrieben werden, dass mindestens eine Lüftungsvorrichtung, insbesondere in Form eines Ventilators, derart angeordnet ist, dass ein in dem Korpus befindliches Gas, insbesondere Luft, innerhalb des Korpus an der Kaltseite des Peltier-Elements entlang förderbar ist.

In einer weiteren praktischen Ausführungsform eines erfindungsgemäßen Schranks ist der Korpus in geschlossenem Zustand der mindestens einen Öffnung insoweit dicht verschlossen, als zumindest kein aktiver Luftaustausch mit der Umgebung stattfindet. In diesem Fall sind die in einem erfindungsgemäßen Schrank angeordneten Systeme wirksam vor Rauchgasen geschützt, die in der Umgebung des erfindungsgemäßen Schranks auftreten können. Vorzugsweise ist der Korpus zusätzlich auch wasserdicht verschlossen. Dies kann insbesondere durch Anordnung geeigneter Dichtungen im Bereich einer Verschlussklappe (Tür) erfolgen. Eine solche Verschlussklappe kann insbesondere über ein einfaches, außenseitig oder innenseitig angeordnetes Drehscharnier und/oder Schwenkscharnier an dem Korpus fixiert sein. Ebenfalls möglich ist es, ein Mehrgelenkscharnier zur Verbindung von Verschlussklappe und Korpus vorzusehen, insbesondere ein innenseitig angeordnetes Mehrgelenkscharnier in Verbindung mit einer Treppenfalz im Bereich der Stoßstelle(n) zwischen Verschlussklappe und Korpus.

Die Erfindung betrifft auch einen wie vorstehend beschriebenen Schrank zur Installation von IT-, EDV-, Netzwerk- und/oder Telekommunikationssystemen, wobei der Schrank einen Korpus sowie mindestens eine verschließbare Öffnung zur Installation und Wartung von innerhalb des Korpus anordenbaren Systemen aufweist, bei welchem die mindestens eine verschließbare Öffnung ein außerhalb und/oder innerhalb des Korpus angelenktes Mehrgelenkscharnier umfasst, das ein Aufschwenken einer Verschlussklappe nach Außen ermöglicht. Dabei ist das Aufschwenken vorzugsweise kinematisch so vorgesehen, dass zunächst eine rein translatorische Verfahrbewegung über einen ersten Verfahrweg realisiert ist und erst anschließend eine Schwenkbewegung einsetzt. Dies ermöglicht es, eine Verschlussklappe mit einer sogenannten Treppenfalz zu realisieren, die von Innen angelenkt und zugleich mit einem effizienten Dichtkonzept versehen sein kann. Das Mehrgelenkscharnier weist vorzugsweise einen Scherenmechanismus auf. Alternativ oder in Ergänzung dazu ist der Drehpunkt eines solchen Mehrgelenkscharniers so ausgelegt, dass sich dieser außerhalb des Gehäuses befindet. Auf Einzelheiten dazu wird in Verbindung mit der Figurenbeschreibung noch näher eingegangen.

In einer weiteren praktischen Ausführungsform eines erfindungsgemäßen Schranks mit Mehrgelenkscharnier umfasst das Mehrgelenkscharnier zwei, sich scherenartig überkreuzende Scherenstangen, die hintereinander und/oder übereinander angeordnet sind.

Der Wandaufbau besteht aus einer Innenschale aus Stahl, einer Isolationsschicht und einer Außenschale aus Stahl. Durch die hohe Isolationswirkung der Isolationsschicht wird ein hoher Brandschutz, speziell für IT-Komponenten, gewährleistet. Die verschiedenen Dichtungen und die intumeszierenden Schottsysteme gewährleisten eine Wasser- und Rauchgasdichtigkeit. Durch den mehrschaligen Aufbau mit mehreren Stahlschichten und ein Aufbau der Verschlussklappe (Türaufbau) ohne äußere Angriffspunkte ist ein hoher Einbruchschutz gewährleistet. Darüber hinaus führt der Stahlkorpus zu einem hohen Schutz vor elektromagnetischen Effekten.

Die Rückkühlung der Außen-Kühlstruktur erfolgt durch Konvektion.

Zur Sicherstellung der hohen Brandschutzwertigkeit werden zur Einführung von Kabeln und Leitungen Schottsysteme ausgebildet. Diese bestehen aus einer Hülse aus intumeszierendem Material und Stopfen eines weicheren intumeszierenden Materials, welches sich um die Leitungen anschmiegt. Das intumeszierende Material vergrößert bei Erhitzung im Brandfall sein Volumen enorm und versiegelt und schützt damit das Kabelschott.

Die Scharniere sind bei einem Einbruch üblicherweise der schwächste Punkt der Verschlussklappe (Tür) und damit der Hauptangriffspunkt. Außenliegende Scharniere können z.B. abgesägt oder aufgehebelt werden. Innenliegende Scharniere bieten dagegen keinen Angriffspunkt von außen und somit einen hohen Einbruchschutz.

Der Aufbau der Türöffnung und des Türblatts als verschränkte Treppenfalz lässt die Hitze im Brandfall oder Wasser nicht direkt eindringen. Darüber hinaus sorgen die auf den Stufen angebrachten intumeszierenden und abdichtenden Dichtungen für Dichtigkeit gegen Hitze, Wasser und Rauchgase.

Das Schloss sitzt ebenfalls geschützt im Inneren und bietet keine Angriffsfläche.

Die Tür ist grifflos ausgeführt und verfügt über ein mechanisches Öffnungssystem. Dieses besteht aus einer stiftförmigen Konstruktion, welche ausfährt wenn die Tür angetippt wird und beim Schließen der Tür wieder einfährt.

Die passive Kühlung bzw. Wärmeabführung an die Umgebungsluft ohne außenliegende Lüfter führt zu einer hohen Geräuschdämmung bzw. Geräuschlosigkeit des Systems.

Weitere praktische Ausführungsformen und Vorteile der Erfindung sind nachfolgend im Zusammenhang mit den Zeichnungen beschrieben. Es zeigen:
- Fig. 1: einen erfindungsgemäßen Schrank in einer ersten Ausführungsform in einer Horizontalschnittdarstellung mit Blick von oben und geöffneter Verschlussklappe ohne weitere Elemente,
- Fig. 2: den Schrank aus Fig. 1 in einer Horizontalschnittdarstellung mit Blick von oben und geschlossener Verschlussklappe ohne weitere Elemente,
- Fig. 3: den Schrank aus Fig. 1 in einer Horizontalschnittdarstellung mit Blick von oben, geschlossener Verschlussklappe und schematischer Darstellung eines installierten IT-Systems und der Luftführung,
- Fig. 4: den Schrank aus Fig. 1 in einer Vertikalschnittdarstellung in einer Ansicht von vorne ohne die Verschlussklappe und
- Fig. 5: einen erfindungsgemäßen Schrank in einer zweiten Ausführungsform in einer Vertikalschnittdarstellung.

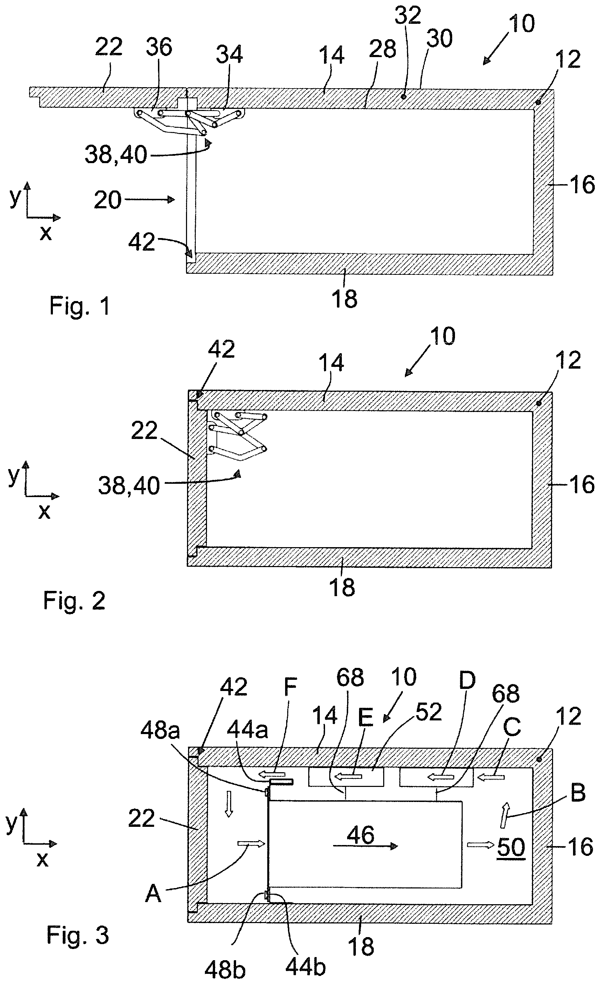

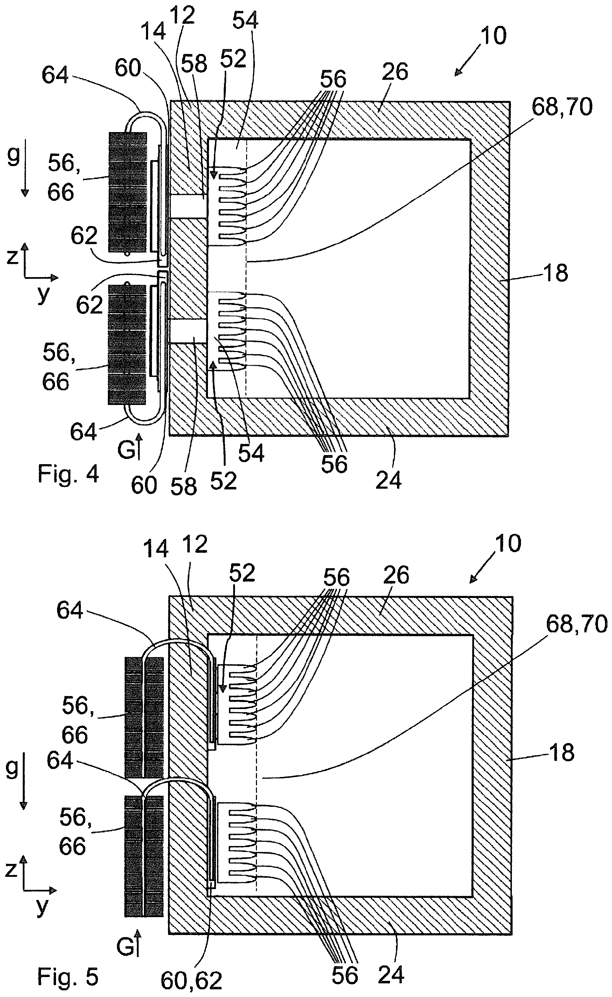

In den Fig. 1 bis 4 ist eine erste Ausführungsform eines erfindungsgemäßen Schranks 10 dargestellt, wobei die Fig. 1 bis 3 den Schrank 10 in einer Horizontalschnittdarstellung in einer Ansicht von oben zeigen und Fig. 4 den Schrank 10 in einer Vertikalschnittdarstellung mit Blick von vorne in die Öffnung zeigt. Der Schrank 10 umfasst einen Korpus 12 mit einer ersten Seitenwand 14, einer Rückwand 16 und einer zweiten Seitenwand 18. Gegenüber der Rückwand 16 befindet sich eine verschließbare Öffnung 20, die mittels einer als Tür ausgebildeten Verschlussklappe 22, wie in Fig. 1 gezeigt, geöffnet und, wie in Fig. 2 gezeigt, verschlossen sein kann.

Wie in Fig. 4 erkennbar ist, weist der Korpus 12 ferner eine Bodenwand 24 und eine Deckwand 26 auf. Der erfindungsgemäße Schrank 10 gemäß den Fig. 1 bis 4 ist daher insgesamt quaderförmig ausgebildet.

Der Korpus 12 ist in der gezeigten Ausführungsform gemäß den Fig. 1 bis 4 dadurch gebildet, dass zwischen einem Innenelement 28 und einem Außenelement 30 ein Isolierwerkstoff 32 angeordnet ist. Das Innenelement 28 und das Außenelement 30 sind in der gezeigten Ausführungsform durch dünne Bleche realisiert, vorliegend durch etwa 1 mm dicke Bleche aus einem Metallwerkstoff, insbesondere aus Stahl oder Aluminium.

Wie in den Fig. 1 und 2 zu erkennen ist, ist an der ersten Seitenwand 14 ein erstes Befestigungselement 34 und an dem Verschlusselement 22 ein zweites Befestigungselement 36 eines diese beiden Befestigungselemente 34, 36 verbindenden Mehrgelenkscharniers 38 in Form eines Scherenmechanismus 40 befestigt.

In den Fig. 1 und 2 ist ferner gut zu erkennen, dass der Bereich, in welchen die Verschlussklappe 22 an den Korpus 12 angrenzt, mittels einer sogenannten Treppenfalz 42 derart gestaltet ist, dass drei jeweils senkrecht zueinander ausgerichtete Flächen als Berührflächen zwischen Verschlussklappe 22 und Korpus 12 im geschlossenen Zustand gemäß Fig. 2 vorgesehen sind. Im Bereich der Treppenfalz 42 sind in den Figuren nicht dargestellte Dichtelemente angeordnet, insbesondere drei unterschiedliche Dichtelemente. Diese dienen insbesondere dazu, eine Wasserdichtheit und eine Gasdichtheit zu erzielen. Darüber hinaus kann mit Hilfe solcher Dichtelemente ein Wärmeeintrag von außen in den erfindungsgemäßen Schrank 10 verringert bzw. vollständig vermieden werden, insbesondere wenn außenseitig des Schranks 10 plötzlich größere, nicht bestimmungsgemäße Temperaturen auftreten, beispielsweise falls es zu einem Brand in dem Gebäude oder der Umgebung kommt, wo der Schrank 10 sich gerade befindet.

Um ein Öffnen und Schließen der Verschlussklappe 22 wie in den Fig. 1 und 2 gezeigt zu ermöglichen, ist der Scherenmechanismus 40 derart ausgelegt, dass er in einer ersten Öffnungsphase ausgehend von der in Fig. 2 gezeigten verschlossenen Position der Verschlussklappe 22 zunächst eine rein translatorische Richtung entgegen des Pfeils x ermöglicht und erst nach dem Ausfahren aus der Treppenpfalz 42 in eine Verschwenkbewegung übergeht.

In Fig. 3 wurde auf die Darstellung des Scherenmechanismus 40 verzichtet. Stattdessen wurden im Inneren des Korpus 12 als Mittel zur Aufnahme von und Verbindung mit eines IT-, EDV-, Netzwerk- und/oder Telekommunikationssystem in genormten Standardgrößen vorgesehene Schienen 44a, 44b dargestellt. An diesen Schienen 44a, 44b ist in Fig. 3 exemplarisch ein Server 46 mittels entsprechender Schrauben 48a, 48b befestigt.

In Fig. 3 ist die Luftzirkulation durch einen erfindungsgemäßen Schrank 10 dargestellt. Luft wird, beispielsweise gefördert mittels eines nicht dargestellten Ventilators oder eines sonstigen geeigneten Mittels gemäß dem Pfeil A von vorne in Richtung Rückwand 16 hindurchgefördert und von dort in Richtung des Pfeils B zu einer als Zwangsluftführung ausgebildeten Rückströmung in Richtung des Pfeils C geleitet. Luft, die durch den Server 46 hindurch in den Raum 50 zwischen dem Server 46 und der Rückwand 16 gelangt ist, kann ausschließlich in Richtung des Pfeils C entlang der ersten Seitenwand 14 zwischen dem Server 46 und der Seitenwand 14 gemäß den Pfeilen D, E und F in Richtung der Verschlussklappe 22 zurückströmen. Die Luft strömt dabei durch insgesamt vier Innen-Kühlstrukturen 52, von welchen in den Fig. 3 und 4 jeweils zwei Innen-Kühlstrukturen 52 gezeigt sind. In der gezeigten Ausführungsform des erfindungsgemäßen Schranks 10 gemäß den Fig. 1 bis 4 sind jeweils zwei Innen-Kühlstrukturen 52 in Längsrichtung der ersten Seitenwand 14 hintereinander und übereinander angeordnet.

Wie in Fig. 4 erkennbar ist, sind die Innen-Kühlstrukturen 52 rippenartig ausgebildet und derart angeordnet, dass eine flächige Platte 54 mit ihrer Rückseite an der Innenfläche der ersten Seitenwand 14 anliegt und sich ausgehend von der Vorderseite dieser Platte 54 rippenartig in Querrichtung (y-Richtung) in das Innere des Schranks 10 hinein erstreckt.

Von der Rückseite der Platten 54 der Kühlstrukturen 52 erstreckt sich jeweils ein Metallelement 58 durch die erste Seitenwand 14 hindurch zur Außenseite des Schranks 10. Dort ist das Metallelement 58 mit der Kaltseite eines Peltier-Elements 60 verbunden. Die Kaltseite des Peltier-Elements 60 befindet sich daher auf der dem Korpus 12 des Schranks 10 zugewandten Seite. Gegenüberliegend befindet sich die Warmseite des Peltier-Elements 60. Die Warmseite ist in direktem Kontakt mit einer Adapterplatte 62. In der gezeigten Ausführungsform sind mehrere Adapterplatten 62 vorgesehen, wobei jede Adapterplatte 62 zur Aufnahme von einem Wärmerohr 64 oder - vorzugsweise - mehreren Wärmerohren 64 dient. In der gezeigten Ausführungsform nehmen insgesamt vier Adapterplatten 62 jeweils 5-10 Wärmerohre 64 auf. Die Wärmerohre 64 erstrecken sich in der gezeigten Ausführungsform bogenförmig von der Adapterplatte 62 zunächst ungefähr parallel zu der ersten Seitenwand 14 und dann bogenförmig derart, dass sich das Wärmerohr 64 von der ersten Seitenwand 14 entfernt. In der gezeigten Ausführungsform entspricht der Bogen einem Halbkreis, so dass das gegenüberliegende Ende des Wärmerohres 64 parallel zu dem vom Adapterelement 62 aufgenommenen Ende angeordnet ist.

Im Bereich des von dem Korpus 12 entfernten Endes des Wärmerohres 64 sind als Außen-Kühlstrukturen 56 dienende Lamellen 66 angeordnet, um eine Kühlung des Wärmerohres 64 in einem von dem Korpus 12 beabstandeten Bereich durch Konvektion zu bewirken. Die Lamellen 66 sind in der gezeigten Ausführungsform so angeordnet, dass Luft in Richtung des Pfeils G von unten nach oben durch die Lamellen 66 hindurch strömen kann.

Fig. 5 zeigt einen erfindungsgemäßen Schrank 10 in einer zweiten Ausführungsform in einer Vertikalschnittdarstellung. Für die Beschreibung dieser zweiten Ausführungsform werden für identische oder zumindest funktionsgleiche Elemente wie bei der ersten Ausführungsform die gleichen Bezugszeichen verwendet wie in den Fig. 1 bis 4. Die Ausführungsform gemäß Fig. 5 unterscheidet sich im Wesentlichen dadurch, dass das Peltier-Element 60 hier gemeinsam mit einer Adapterplatte 62 zur Aufnahme von Wärmerohren 64 innenseitig des Schranks 10 unmittelbar an dem Korpus 12, hier an der ersten Seitenwand 14, angeordnet sind. Dabei ist es sowohl möglich, die Adapterplatte 62 integral und somit einstückig an dem Peltier-Element 60 auszubilden, wie in Fig. 5 dargestellt, oder alternativ, ein Peltier-Element 60 sowie eine Adapterplatte 62 als separate Elemente so anzuordnen, vorzugsweise derart, dass die Warmseite des Peltier-Elements 60 unmittelbar an die Adapterplatte 62 angrenzend angeordnet ist.

Auch bei der in Fig. 5 gezeigten Ausführungsform nimmt jede Adapterplatte 62 mehrere Wärmerohre 64 auf. Die Wärmerohre 64 erstrecken sich von der jeweiligen Adapterplatte 62 durch den Korpus 12 hindurch, hier durch die erste Seitenwand 12 hindurch in den Bereich außerhalb des Korpus 12. An dem außenseitigen Ende der Wärmerohre 64 sind dann wiederum jeweils als Außen-Kühlstrukturen 56 vorgesehene Lamellen 66 angeordnet, über welche Wärme durch Konvektion abgeführt wird. Die Lamellen 66 sind wiederum so ausgebildet, dass Luft während der Konvektion von unten nach oben entlang des Pfeils G gegen die Schwerkraft g nach oben strömt.

Der Vollständigkeit halber wird noch daraufhin gewiesen, dass zur Erzielung einer Zwangs-Luftführung entlang der Pfeile C, D, E und F zwischen dem Server 46 und der ersten Seitenwand 14 geeignete Schottungen 68 vorgesehen sind, die verhindern, dass Luft anders als durch die Kühlstrukturen 52 von dem Raum 50 im Bereich der Rückwand 16 in Richtung Verschlussklappe 22 gelangen kann. Die Schottungen 68 sind in Fig. 4 durch die gestrichelte Linie 70 angedeutet.

Optional können auch in Hochrichtung (z-Richtung) zwischen den Kühlstrukturen 52 entsprechende Schottungen (nicht dargestellt) angeordnet sein, um zu verhindern, dass zwischen zwei in Hochrichtung (z-Richtung) zueinander beabstandeten Kühlstrukturen 52 Luft hindurch strömen kann. In diesem Fall ist eine Zwangs-Luftführung ausschließlich durch die Kühlstrukturen 52 möglich.

Ebenfalls optional können im Bereich des Raumes 50 zusätzliche Ventilatoren in dem Schrank 10 vorgesehen sein, um den Volumenstrom der durch den Schrank 10 geförderten Luft zu erhöhen. Das Gleiche gilt auch für andere Positionen innerhalb des Schranks 10.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

Insbesondere wird darauf hingewiesen, dass anstelle eines Servers 46 auch ein oder mehrere IT-, EDV-, Netzwerk- und/oder Telekommunikationssysteme in einem erfindungsgemäßen Schrank 10 installiert sein können.

Ferner wird darauf hingewiesen, dass unter Wärmerohren im Sinne der Erfindung nicht nur nach dem Dochtprinzip arbeitende "heat pipes", sondern auch nach dem Schwerkraftprinzip arbeitende Wärmerohre verstanden werden. "Heat pipes" sind aber die bevorzugten Elemente, weil diese schwerkraftunabhängig funktionieren und in beliebiger Ausrichtung verbaut werden können.

### Bezugszeichenliste

- 10: Schrank
- 12: Korpus
- 14: Seitenwand
- 16: Rückwand
- 18: Seitenwand
- 20: verschließbare Öffnung
- 22: Verschlussklappe
- 24: Bodenwand
- 26: Deckwand
- 28: Innenelement
- 30: Außenelement
- 32: Isolierwerkstoff
- 34: Befestigungselement
- 36: Befestigungselement
- 38: Mehrgelenkscharnier
- 40: Scherenmechanismus
- 42: Treppenfalz
- 44a: Schiene
- 44b: Schiene
- 46: Server
- 48a: Schraube
- 48b: Schraube
- 50: Raum
- 52: Innen-Kühlstrukturen
- 54: Platte
- 56: Außen-Kühlstruktur
- 58: Metallelement
- 60: Peltier-Element
- 62: Adapterplatte
- 64: Wärmerohr
- 66: Lamelle
- 68: Schottung
- 70: gestrichelte Linie

## Patentansprüche

1. Schrank (10) zur Installation von IT-, EDV-, Netzwerk- und/oder Telekommunikationssystemen, wobei der Schrank (10) einen Korpus (12) sowie mindestens eine verschließbare Öffnung (20) zur Installation und Wartung von innerhalb des Korpus (12) anordenbaren Systemen aufweist,
**dadurch gekennzeichnet,**
**dass** eine passive Kühlung ohne außenseitig des Korpus angeordnete Lüfter vorgesehen ist, wobei zur Realisierung der passiven Kühlung nur in oder nur an dem Korpus (12) mindestens ein Peltier-Element (60) mit einer Warmseite und einer Kaltseite angeordnet ist, wobei die Warmseite über mindestens ein wärmeleitend verbundenes Wärmerohr (64) mit mindestens einer außenseitig des Korpus (12) angeordneten Außen-Kühlstruktur (56) funktional verbunden ist und wobei
a) eine Zwangs-Luftführung eines Kühlluftstromes zumindest teilweise durch eine Innen-Kühlstruktur (52) vorgesehen ist und
b) mindestens eine Wand (14, 16, 18, 24, 26) als Isolationswand ausgebildet ist.

2. Schrank (10) nach dem vorstehenden Anspruch, **dadurch gekennzeichnet, dass** das mindestens eine Peltier-Element (60) innerhalb des Korpus (12) angeordnet ist und mindestens ein Wärmerohr (64) durch zumindest eine Wand (14, 16, 18, 24, 26) des Korpus (12) geführt ist.

3. Schrank (10) nach einem der vorstehenden Ansprüche, **dadurch gekennzeichnet, dass** die Warmseite des mindestens einen Peltier-Elements (60) unmittelbar an einer Innenwand des Korpus (12) anliegend und/oder die Kaltseite des mindestens einen Peltier-Elements (60) unmittelbar an einer Außenwand des Korpus (12) anliegend angeordnet ist.

4. Schrank (10) nach dem vorstehenden Anspruch, **dadurch gekennzeichnet, dass** sich die mindestens eine Kühlstruktur über einen Teilbereich der Fläche einer Außenwand des Korpus (12) erstreckt und/oder sich das mindestens eine Peltier-Element (60) über einen Teilbereich der Fläche einer Innenwand des Korpus (12) erstreckt.

5. Schrank (10) nach einem der vorstehenden Ansprüche, **dadurch gekennzeichnet, dass** das mindestens eine Peltier-Element (60) außerhalb des Korpus (12) angeordnet ist und die Wärmerohre (64) in unmittelbarer Umgebung des Peltier-Elements (60) wärmeleitend mit diesem verbunden angeordnet sind.

6. Schrank (10) nach dem vorstehenden Anspruch, **dadurch gekennzeichnet, dass** die Wärmerohre (64) außerhalb des Korpus (12) angeordnet sind, wobei ein Ende der Wärmerohre (64) wärmeleitend mit Außen-Kühlstrukturen (56) verbunden sind und ein anderes Ende in unmittelbarer Umgebung des mindestens einen Peltier-Elements (60) angeordnet ist.
a)

7. Schrank (10) nach einem der vorstehenden Ansprüche, **dadurch gekennzeichnet, dass**
a) in dem Korpus (12) Mittel zur Aufnahme einer Haltevorrichtung und/oder eine Haltevorrichtung zur Aufnahme von und Verbindung mit IT-, EDV-, Netzwerk- und/oder Telekommunikationssystemen in genormten Standardgrößen angeordnet sind und/oder
b) in dem Korpus (12) mindestens eine Lüftungsvorrichtung derart angeordnet ist, dass ein in dem Korpus (12) befindliches Gas innerhalb des Korpus an der Kaltseite des Peltier-Elements (60) entlang förderbar ist.

8. Schrank (10) nach einem der vorstehenden Ansprüche, **dadurch gekennzeichnet, dass** die mindestens eine verschließbare Öffnung (20) ein außerhalb und/oder innerhalb des Korpus (12) angelenktes Mehrgelenkscharnier (38) umfasst, das ein Aufschwenken einer Verschlussklappe (22) nach außen ermöglicht.

9. Schrank (10) nach dem vorstehenden Anspruch, **dadurch gekennzeichnet, dass** das Mehrgelenkscharnier (38) zwei, sich scherenartig überkreuzende Scherenstangen umfasst, die hintereinander und/oder übereinander angeordnet sind.

## Claims

1. Cabinet (10) for the installation of IT, EDP, network and/or telecommunications systems, the cabinet (10) having a body (12) and at least one closable opening (20) for the installation and maintenance of systems which can be arranged within the body (12),
**characterised in that**
a passive cooling is provided without fans arranged on the outside of the cabinet, at least one Peltier element (60) having a hot side and a cold side being arranged only in or only on the body (12) in order to realise the passive cooling, the hot side being functionally connected to at least one external cooling structure (56) arranged on the outside of the body (12) via at least one heat pipe (64) connected in a heat-conducting manner, and
a) a forced air flow of a cooling air stream being provided at least partially through an internal cooling structure (52)
and
b) at least one wall (14, 16, 18, 24, 26) being designed as an insulating wall.

2. Cabinet (10) according to the preceding claim, **characterised in that** the at least one Peltier element (60) is arranged inside the body (12) and at least one heat pipe (64) is guided through at least one wall (14, 16, 18, 24, 26) of the body (12).

3. Cabinet (10) according to one of the preceding claims, **characterised in that** the hot side of the at least one Peltier element (60) is arranged in direct contact with an inner wall of the body (12) and/or the cold side of the at least one Peltier element (60) is arranged in direct contact with an outer wall of the body (12).

4. Cabinet (10) according to the preceding claim, **characterised in that** the at least one cooling structure extends over a partial area of the surface of an outer wall of the body (12) and/or the at least one Peltier element (60) extends over a partial area of the surface of an inner wall of the body (12).

5. Cabinet (10) according to one of the preceding claims, **characterised in that** the at least one Peltier element (60) is arranged outside the body (12) and the heat pipes (64) are arranged in the immediate vicinity of the Peltier element (60) and are connected thereto in a heat-conducting manner.

6. Cabinet (10) according to the preceding claim, **characterised in that** the heat pipes (64) are arranged outside the body (12), one end of the heat pipes (64) being connected in a heat-conducting manner to external cooling structures (56) and another end being arranged in the immediate vicinity of the at least one Peltier element (60).

7. Cabinet (10) according to one of the preceding claims, **characterised in that**
a) means for receiving a holding device and/or a holding device for receiving and connecting to IT, EDP, network and/or telecommunication systems in standardised standard sizes are arranged in the body (12) and/or
b) at least one ventilation device is arranged in the body (12) in such a way that a gas located in the body (12) can be conveyed within the body along the cold side of the Peltier element (60).

8. Cabinet (10) according to one of the preceding claims, **characterised in that** the at least one closable opening (20) comprises a multi-joint hinge (38) which is hinged outside and/or inside the body (12) and enables a closing flap (22) to be swung open outwards.

9. Cabinet (10) according to the preceding claim, **characterised in that** the multiple-joint hinge (38) comprises two scissor-like intersecting scissor rods which are arranged one behind the other and/or one above the other.

## Revendications

1. Armoire (10) pour l'installation de systèmes IT, informatiques, de réseau et/ou de télécommunication, l'armoire (10) présentant un corps (12) ainsi qu'au moins une ouverture (20) pouvant être fermée pour l'installation et la maintenance de systèmes pouvant être disposés à l'intérieur du corps (12),
**caractérisé en ce que**
qu'il est prévu un refroidissement passif sans ventilateurs disposés à l'extérieur du corps, au moins un élément Peltier (60) avec un côté chaud et un côté froid étant disposé uniquement dans ou uniquement sur le corps (12) pour réaliser le refroidissement passif, le côté chaud étant relié fonctionnellement par au moins un caloduc (64) relié de manière thermoconductrice à au moins une structure de refroidissement extérieure (56) disposée à l'extérieur du corps (12), et dans lequel
a) un guidage forcé d'un flux d'air de refroidissement est prévu au moins partiellement à travers une structure de refroidissement interne (52)
et
b) au moins une paroi (14, 16, 18, 24, 26) est conçue comme une paroi d'isolation.

2. Armoire (10) selon la revendication précédente, **caractérisée en ce que** le au moins un élément Peltier (60) est disposé à l'intérieur du corps (12) et au moins un caloduc (64) est passé à travers au moins une paroi (14, 16, 18, 24, 26) du corps (12).

3. Armoire (10) selon l'une des revendications précédentes, **caractérisée en ce que** le côté chaud du au moins un élément Peltier (60) est disposé directement contre une paroi intérieure du corps (12) et/ou le côté froid du au moins un élément Peltier (60) est disposé directement contre une paroi extérieure du corps (12).

4. Armoire (10) selon la revendication précédente, **caractérisée en ce que** ladite au moins une structure de refroidissement s'étend sur une partie de la surface d'une paroi extérieure du corps (12) et/ou ledit au moins un élément Peltier (60) s'étend sur une partie de la surface d'une paroi intérieure du corps (12).

5. Armoire (10) selon l'une des revendications précédentes, **caractérisée en ce que** ledit au moins un élément Peltier (60) est disposé à l'extérieur du corps (12) et **en ce que** les caloducs (64) sont disposés à proximité immédiate de l'élément Peltier (60) et reliés à celui-ci de manière à conduire la chaleur.

6. Armoire (10) selon la revendication précédente, **caractérisée en ce que** les caloducs (64) sont disposés à l'extérieur du corps (12), une extrémité des caloducs (64) étant reliée de manière thermoconductrice à des structures de refroidissement extérieures (56) et une autre extrémité étant disposée à proximité immédiate du au moins un élément Peltier (60).

7. Armoire (10) selon l'une des revendications précédentes, **caractérisée en ce que**
a) dans le corps (12) sont disposés des moyens pour recevoir un dispositif de maintien et/ou un dispositif de maintien pour recevoir et connecter des systèmes IT, informatiques, de réseau et/ou de télécommunication de tailles standard normalisées et/ou
b) au moins un dispositif de ventilation est disposé dans le corps (12) de telle sorte qu'un gaz se trouvant dans le corps (12) peut être transporté à l'intérieur du corps le long du côté froid de l'élément Peltier (60).

8. Armoire (10) selon l'une des revendications précédentes, **caractérisée en ce que** ladite au moins une ouverture (20) pouvant être fermée comprend une charnière à plusieurs articulations (38) articulée à l'extérieur et/ou à l'intérieur du corps (12), qui permet de faire pivoter vers l'extérieur un volet de fermeture (22).

9. Armoire (10) selon la revendication précédente, **caractérisée en ce que** la charnière à articulations multiples (38) comprend deux barres de cisaillement qui se croisent à la manière de ciseaux et qui sont disposées l'une derrière l'autre et/ou l'une au-dessus de l'autre.
